# EUROPEAN PATENT APPLICATION

(11) **EP 4 207 968 A1**
(43) Date of publication of application: **05.07.2023**
(21) Application number: 22209812.1
(22) Date of filing: 28.11.2022
(51) Int. Cl.: H10K 50/19, H10K 50/13, H10K 101/40

(54) **LIGHT-EMITTING DEVICE AND LIGHT-EMITTING DISPLAY DEVICE INCLUDING THE SAME**

(30) Priority: 31.12.2021 KR 20210194782
(71) Applicant: LG Display Co., Ltd., Seoul 150-721 (KR)
(72) Inventor: PARK, Jin Hwan, Paju-si, Gyeonggi-do (KR); KIM, Ji Yun, Paju-si, Gyeonggi-do (KR); KIM, Yong Hwan, Paju-si, Gyeonggi-do (KR); KIM, Tae Shick, Paju-si, Gyeonggi-do (KR); KIM, Kwang Hyun, Paju-si, Gyeonggi-do (KR); KIM, Dong Hyuk, Paju-si, Gyeonggi-do (KR)
(74) Representative: Viering, Jentschura & Partner mbB Patent- und Rechtsanwälte

(57) **Abstract**

Disclosed are a light-emitting device including a first light-emitting layer such that a dopant having a hole trapping property is adjacent to a hole transport layer, and a second light-emitting layer that comes into contact with the first light-emitting layer to induce main light emission, thereby widening a light-emitting region and improving the efficiency and lifespan of the light-emitting layer, and a light-emitting display device including the light-emitting device.

## Description

This application claims the benefit of Korean Patent Application No. 10-2021-0194782, filed on December 31, 2021.

### BACKGROUND OF THE INVENTION

### Field of the Invention

The present invention relates to a light-emitting device and a light-emitting display including the same.

### Discussion of the Related Art

Recently, a light-emitting display that does not require a separate light source and has a light-emitting device in a display panel without a separate light source to make the display compact and realize clear color has been considered a competitive application.

Light-emitting devices currently used in light-emitting displays require higher efficiency in order to realize excellent image quality.

Meanwhile, a tandem device in which light-emitting layers emitting light of different colors are provided in different stacks has been considered as a light-emitting device.

However, since color light-emitting layers have different efficiencies for materials and human visibility is also different for each color, research has been conducted on color light-emitting layers having low visibility and low efficiency.

### SUMMARY OF THE DISCLOSURE

Accordingly, the present disclosure is directed to a light-emitting device and a light-emitting display including the same that substantially obviate one or more problems due to the limitations and disadvantages of the related art.

A tandem light-emitting device using a plurality of stacks has a difference in efficiency between stacks emitting light of different colors and requires higher blue efficiency from the viewpoint of color temperature.

A method of increasing a carrier transport effect by changing the material for the transport layer adjacent to the light-emitting layer is considered in order to increase the efficiency of a blue stack emitting blue light. However, this method causes a problem in that the lifespan is reduced due to the formation of a narrow light-emitting region in the light-emitting layer.

The light-emitting device and the light-emitting display according to the present disclosure are devised to solve this problem and a light-emitting region can be increased, efficiency can be improved, and lifespan can be improved by changing the structure of the blue light-emitting layer.

Additional advantages, objects, and features of the disclosure will be set forth in part in the description which follows and in part will become apparent to those having ordinary skill in the art upon examination of the following, or may be learned from practice of the disclosure. The objectives and other advantages of the disclosure may be realized and attained by the structure particularly pointed out in the written description and claims hereof as well as the appended drawings.

To achieve these objects and other advantages in accordance with the purpose of the disclosure, as embodied and broadly described herein, a light-emitting device includes a first light emitting layer including a first dopant having a hole trapping property so as to be adjacent to a hole transport layer, and a second light emitting layer having main light emission in contact with the first light emitting layer. So the light-emitting device according to the disclosure can widen a light-emitting region and improve both luminous efficiency and lifespan.

According to the present invention, a light-emitting device defined in claim 1 is provided. Exemplary embodiments of the invention are defined in the dependent claims.

In accordance with one embodiment of the present disclosure, a light-emitting device includes a first electrode and a second electrode facing each other over a substrate, and a first blue stack, a first charge generation layer, and a phosphorescent stack between the first electrode and the second electrode, wherein the first blue stack sequentially includes (e.g. includes sequentially arranged between the first and second electrodes) a hole transport layer, a first blue light-emitting layer, a second blue light-emitting layer, and an electron transport layer, the first and second blue light-emitting layers include the same host BH and include different first and second blue dopants, respectively, and the first blue dopant has a higher highest occupied molecular orbital (HOMO) energy level than a HOMO energy level of the hole transport layer.

In accordance with another embodiment of the present disclosure, a light-emitting device includes a first electrode and a second electrode facing each other over a substrate, and a first blue stack, a first charge generation layer, a phosphorescent stack and a second blue stack between the first electrode and the second electrode, wherein the first blue stack sequentially includes (e.g. includes sequentially arranged between the first and second electrodes) a first hole transport layer, a first blue light-emitting unit, and a first electron transport layer, the second blue stack sequentially includes (e.g. includes sequentially arranged between the first and second electrodes) a second hole transport layer, a second blue light-emitting unit, and a second electron transport layer, at least one of the first and second blue light-emitting units includes first and second blue light-emitting layers, and the first and second blue light-emitting layers include the same host BH and comprise different first and second blue dopants, respectively, and the first blue dopant has a higher HOMO energy level than a HOMO energy level of the first hole transport layer or the second hole transport layer.

In accordance with another aspect of the present disclosure, a light-emitting display device includes a substrate including a plurality of subpixels, a thin film transistor provided in each of the subpixels on the substrate, and the light-emitting device connected to the thin film transistor in at least one of the subpixels.

A light-emitting device according to a first aspect of the present disclosure comprises: a first electrode and a second electrode facing each other over a substrate; and a first blue stack, a first charge generation layer, and a phosphorescent stack between the first electrode and the second electrode, wherein, the first blue stack sequentially comprises a hole transport layer, a first blue light-emitting layer, a second blue light-emitting layer, and an electron transport layer, the first and second blue light-emitting layers comprise the same host BH and comprise different first and second blue dopants, respectively, and the first blue dopant has a higher Highest Occupied Molecular Orbital HOMO energy level than a HOMO energy level of the hole transport layer.

In one or more embodiments, the HOMO energy level of the hole transport layer is between a HOMO energy level of the host and the HOMO energy level of the first blue dopant.

In one or more embodiments, the HOMO energy level of the first blue dopant is at least 0.1 eV higher than the HOMO energy level of the hole transport layer, and the HOMO energy level of the host is at least 0.5 eV lower than the HOMO energy level of the first blue dopant.

In one or more embodiments, a thickness ratio of the first blue light-emitting layer to the second blue light-emitting layer is 1:9 to 8:2, optionally 1:8 to 8:2.

In one or more embodiments, the phosphorescent stack comprises a red light-emitting layer, a yellow-green light-emitting layer and a green light-emitting layer adjacent to the first charge generation layer.

In one or more embodiments, the light-emitting device further comprises at least one second blue stack between the phosphorescent stack and the second electrode.

In one or more embodiments, the second blue stack sequentially comprises the same hole transport layer, the same first blue light-emitting layer, the same second blue light-emitting layer, and the same electron transport layer as those of the first blue stack.

In one or more embodiments, each of the first blue light-emitting layer and the second blue light-emitting layer has an emission peak of 440 nm to 470 nm.

In one or more embodiments, the first blue dopant is present in an amount of 0.1 wt% to 10 wt% in the first blue light-emitting layer, and the second blue dopant is present in an amount of 0.1 wt% to 10 wt% in the second blue light-emitting layer.

In one or more embodiments, an asymmetric hole trap region biased toward the first blue light-emitting layer is generated in the first blue light-emitting layer and the second blue light-emitting layer in contact with each other.

A light-emitting device according to a second aspect of the present disclosure comprises: a first electrode and a second electrode facing each other over a substrate; and a first blue stack, a first charge generation layer, a phosphorescent stack and a second blue stack between the first electrode and the second electrode, wherein, the first blue stack sequentially comprises a first hole transport layer, a first blue light-emitting unit, and a first electron transport layer, the second blue stack sequentially comprises a second hole transport layer, a second blue light-emitting unit, and a second electron transport layer, at least one of the first and second blue light-emitting units comprises first and second blue light-emitting layers, and the first and second blue light-emitting layers comprise the same host BH and comprise different first and second blue dopants, respectively, and the first blue dopant has a higher Highest Occupied Molecular Orbital HOMO energy level than a HOMO energy level of the first hole transport layer or the second hole transport layer.

In one or more embodiments, the HOMO energy level of the first blue dopant is at least 0.1 eV higher than the HOMO energy level of the first hole transport layer or the second hole transport layer, and a HOMO energy level of the host is at least 0.5 eV lower than the HOMO energy level of the first blue dopant.

In one or more embodiments, an asymmetric hole trap region biased toward the first blue light-emitting layer is generated in the first blue light-emitting layer and the second blue light-emitting layer coming into contact with each other.

In one or more embodiments, a thickness ratio of the first blue light-emitting layer to the second blue light-emitting layer is 1:8 to 8:2.

In one or more embodiments, the phosphorescent stack comprises a red light-emitting layer, a yellow-green light-emitting layer and a green light-emitting layer adjacent to the first charge generation layer.

A light-emitting display device according to a third aspect of the present disclosure comprises: a substrate comprising a plurality of subpixels; a thin film transistor provided in each of the subpixels over the substrate; and a light-emitting device described above, connected to the thin film transistor in at least one of the subpixels.

In one or more embodiments, the HOMO energy level of the hole transport layer is between a HOMO energy level of the host and the HOMO energy level of the first blue dopant.

In one or more embodiments, the HOMO energy level of the first blue dopant is at least 0.1 eV higher than the HOMO energy level of the hole transport layer, and the HOMO energy level of the host is at least 0.5 eV lower than the HOMO energy level of the first blue dopant.

In one or more embodiments, an asymmetric hole trap region biased toward the first blue light-emitting layer is generated in the first blue light-emitting layer and the second blue light-emitting layer coming into contact with each other.

In one or more embodiments, a thickness ratio of the first blue light-emitting layer to the second blue light-emitting layer is 1:8 to 8:2.

A light-emitting device according to a fourth aspect of the present disclosure comprises: a first electrode and a second electrode facing each other over a substrate; and a first blue stack and a first charge generation layer between the first electrode and the second electrode, wherein, the first blue stack comprises a first hole transport layer, a first blue light-emitting layer, a second blue light-emitting layer, and a first electron transport layer sequentially arranged between the first electrode and the second electrode, the first and second blue light-emitting layers comprise the same first host, the first blue light-emitting layer comprises a first blue dopant, and the second blue light-emitting layer comprises a second blue dopant different from the first blue dopant, and the first blue dopant has a higher Highest Occupied Molecular Orbital energy level than a Highest Occupied Molecular Orbital energy level of the first hole transport layer.

In one or more embodiments, the Highest Occupied Molecular Orbital energy level of the first hole transport layer is between a Highest Occupied Molecular Orbital energy level of the first host and the Highest Occupied Molecular Orbital energy level of the first blue dopant, wherein optionally the Highest Occupied Molecular Orbital energy level of the first blue dopant is at least 0.1 eV higher than the Highest Occupied Molecular Orbital energy level of the first hole transport layer, and/or the Highest Occupied Molecular Orbital energy level of the first host is at least 0.5 eV lower than the Highest Occupied Molecular Orbital energy level of the first blue dopant.

In one or more embodiments, a thickness ratio of the first blue light-emitting layer to the second blue light-emitting layer is 1:9 to 8:2, optionally 1:8 to 8:2.

In one or more embodiments, the first blue light-emitting layer has an emission peak of 440 nm to 470 nm and/or the second blue light-emitting layer has an emission peak of 440 nm to 470 nm.

In one or more embodiments, the first blue dopant is present in an amount of 0.1 wt% to 10 wt% in the first blue light-emitting layer, and/or the second blue dopant is present in an amount of 0.1 wt% to 10 wt% in the second blue light-emitting layer.

In one or more embodiments, an asymmetric hole trap region biased toward the first blue light-emitting layer is generated in the first blue light-emitting layer and the second blue light-emitting layer in contact with each other.

In one or more embodiments, the light-emitting device further comprises a second blue stack, wherein optionally the second blue stack is positioned between the first blue stack and the second electrode, and further optionally the second blue stack has the same configuration as the first blue stack.

In one or more embodiments, the second blue stack comprises a second hole transport layer, a third blue light-emitting layer, a fourth blue light-emitting layer, and a second electron transport layer sequentially arranged between the first electrode and the second electrode, the third and fourth blue light-emitting layers comprise the same second host, the third blue light-emitting layer comprises a third blue dopant, and the fourth blue light-emitting layer comprises a fourth blue dopant different from the third blue dopant, and the third blue dopant has a higher Highest Occupied Molecular Orbital energy level than a Highest Occupied Molecular Orbital energy level of the second hole transport layer.

In one or more embodiments, the Highest Occupied Molecular Orbital energy level of the second hole transport layer is between a Highest Occupied Molecular Orbital energy level of the second host and the Highest Occupied Molecular Orbital energy level of the third blue dopant, wherein optionally the Highest Occupied Molecular Orbital energy level of the third blue dopant is at least 0.1 eV higher than the Highest Occupied Molecular Orbital energy level of the second hole transport layer, and/or the Highest Occupied Molecular Orbital energy level of the second host is at least 0.5 eV lower than the Highest Occupied Molecular Orbital energy level of the third blue dopant.

In one or more embodiments, a thickness ratio of the third blue light-emitting layer to the fourth blue light-emitting layer is 1:8 to 8:2.

In one or more embodiments, the third blue light-emitting layer has an emission peak of 440 nm to 470 nm and/or the fourth blue light-emitting layer has an emission peak of 440 nm to 470 nm.

In one or more embodiments, the third blue dopant is present in an amount of 0.1 wt% to 10 wt% in the third blue light-emitting layer, and/or the fourth blue dopant is present in an amount of 0.1 wt% to 10 wt% in the fourth blue light-emitting layer.

In one or more embodiments, an asymmetric hole trap region biased toward the third blue light-emitting layer is generated in the third blue light-emitting layer and the fourth blue light-emitting layer in contact with each other.

In one or more embodiments, the light emitting-device further comprises a phosphorescent stack positioned between the first electrode and the second electrode, the phosphorescent stack comprising a red light-emitting layer and/or a yellow-green light-emitting layer and/or a green light-emitting layer adjacent to the first charge generation layer. Optionally, the phosphorescent stack is positioned between the first blue stack and the second blue stack.

A light-emitting display device according to a fifth aspect of the present disclosure comprises: a substrate comprising a plurality of subpixels; a plurality of thin film transistors respectively provided in the subpixels over the substrate; and a light-emitting device described above, connected to at least one of the thin film transistors in at least one of the subpixels.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a cross-sectional view illustrating a light-emitting device according to a first embodiment of the present disclosure;
FIG. 2 is an energy band diagram of a blue light-emitting unit and a peripheral layer of FIG. 1;
FIG. 3 illustrates main light emission and auxiliary light emission generated in the blue light-emitting unit of FIG. 2;
FIG. 4 illustrates a light-emitting region provided in the blue light-emitting unit of FIG. 2;
FIG. 5 is an energy band diagram of an HOD device to determine the I-V characteristics of the first and second blue dopants, and illustrates carrier movement in the HOD device;
FIG. 6 is a graph illustrating the I-V characteristics of the first and second blue dopants, measured through the HOD device of FIG. 5;
FIGS. 7A to 7C are cross-sectional views of light-emitting devices according to second to fourth embodiments of the present disclosure;
FIG. 8 is a graph illustrating the blue lifespan of a first experimental embodiment and the second to fourth embodiments;
FIG. 9 is a cross-sectional view illustrating a specific example of FIG. 7C;
FIG. 10 is a graph showing the 1/By characteristics and lifespan depending on the thickness ratio of the first and second blue light-emitting layers in the blue light-emitting unit in the light-emitting device of the present disclosure;
FIG. 11 is a graph illustrating luminance generated depending on the thickness ratio of first and second blue light-emitting layers in a blue light-emitting unit in the light-emitting device of the present disclosure; and
FIG. 12 is a sectional view illustrating a light-emitting display device using the light-emitting device according to the present disclosure.

### DETAILED DESCRIPTION OF THE INVENTION

Reference will now be made in detail to preferred embodiments of the present disclosure, examples of which are illustrated in the accompanying drawings. Wherever possible, the same reference numbers will be used throughout the drawings to refer to the same or like parts. In the following description of the present disclosure, detailed descriptions of known functions and configurations incorporated herein will be omitted when the same may obscure the subject matter of the present disclosure. In addition, the names of elements used in the following description are selected in consideration of clarity of description of the specification, and may differ from the names of elements of actual products.

In the drawings for explaining the exemplary aspects of the present disclosure, for example, the illustrated shape, size, ratio, angle, and number are given by way of example, and thus, are not limited to the disclosure of the present disclosure. Throughout the present specification, the same reference numerals designate the same constituent elements. In addition, in the following description of the present disclosure, a detailed description of known functions and configurations incorporated herein will be omitted when it may make the subject matter of the present disclosure rather unclear. The terms "comprises," "includes," and/or "has", used in this specification, do not preclude the presence or addition of other elements unless used along with the term "only". The singular forms are intended to include the plural forms as well, unless the context clearly indicates otherwise.

In the interpretation of constituent elements included in the various aspects of the present disclosure, the constituent elements are interpreted as including an error range even if there is no explicit description thereof.

In the description of the various aspects of the present disclosure, when describing positional relationships, for example, when the positional relationship between two parts is described using "on", "above", "below", "next to", or the like, one or more other parts may be located between the two parts unless the term "directly" or "closely" is used.

In the description of the various aspects of the present disclosure, when describing temporal relationships, for example, when the temporal relationship between two actions is described using "after", "subsequently", "next", "before", or the like, the actions may not occur in succession unless the term "directly" or "just" is used therewith.

In the description of the various aspects of the present disclosure, although terms such as, for example, "first" and "second" may be used to describe various elements, these terms are merely used to distinguish the same or similar elements from each other. Therefore, in the present specification, an element indicated by "first" may be the same as an element indicated by "second" without exceeding the technical scope of the present disclosure, unless otherwise mentioned.

The respective features of the various aspects of the present disclosure may be partially or wholly coupled to and combined with each other, and various technical linkages and modes of operation thereof are possible. These various aspects may be performed independently of each other, or may be performed in association with each other.

In the following description of the various embodiments, a "doped" layer refers to a layer containing a host material and a dopant material that has properties different from the host material. Examples of host and dopant materials may include an N-type material and a P-type material or an organic material and an inorganic material. Apart from the differences in properties, the host and dopant materials may also differ in terms of their amounts in the doped layer. For example, the host material may be a major component while the dopant material may be a minor component. In some embodiments, an amount of dopant material is less than 30 wt%, based on a total weight of the doped layer.

In some embodiments, a layer may be made from organic materials only, which may include N-type and P-type materials. When the amount of the N-type material is less than 30 wt% or the content of the P-type material is less than 30 wt%, the layer may be a "doped" layer.

The term "undoped" describes layers that are not "doped." For example, a layer may be an "undoped" layer when it is formed of a single material or a mix of materials having the same or similar properties. As a further example, a layer may be an "undoped" layer when at least one of materials forming a layer is P-type and none of the materials forming the layer is N-type. As another example, a layer may be an "undoped" layer when at least one of the materials forming a layer is organic and none of the materials forming the layer is inorganic.

Advantages and features of the present disclosure and methods of achieving the same will be more clearly understood from embodiments described below with reference to the accompanying drawings. However, the present disclosure is not limited to the following embodiments and may be implemented in various different forms. The embodiments are provided merely to complete the disclosure of the present disclosure and to fully inform a person having ordinary skill in the art to which the present disclosure pertains of the category of the invention. The invention is defined only by the category of the claims.

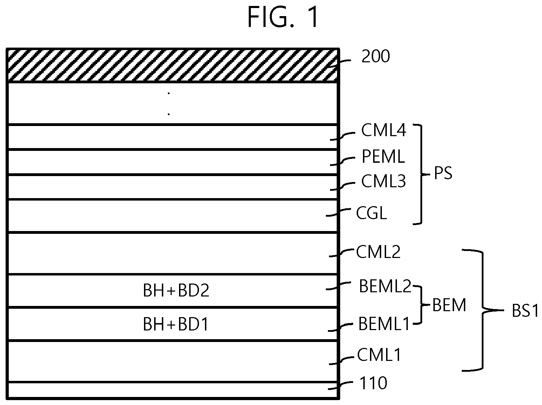

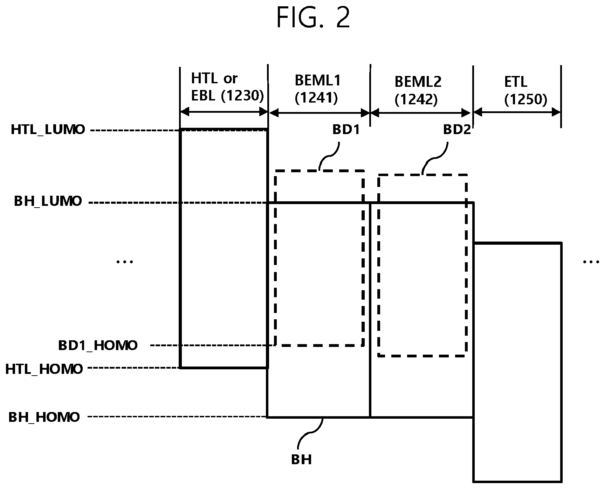

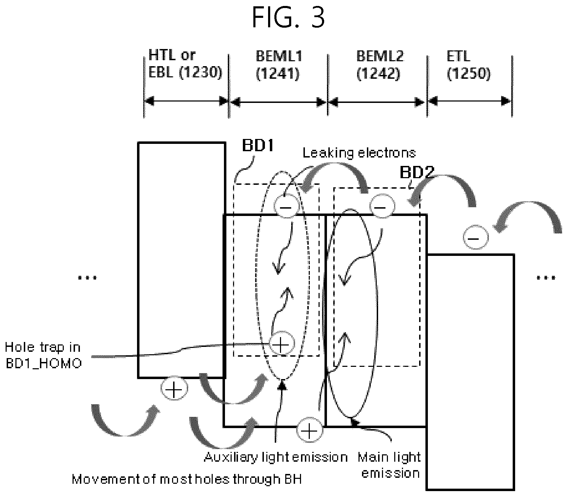

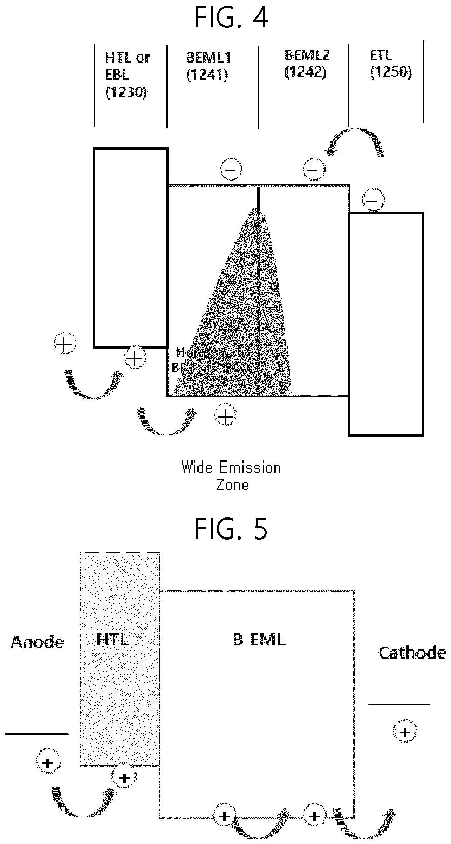

FIG. 1 is a cross-sectional view illustrating a light-emitting device according to a first embodiment of the present disclosure, and FIG. 2 is an energy band diagram of a blue light-emitting unit and a peripheral layer of FIG. 1. In addition, FIG. 3 illustrates main light emission and auxiliary light emission generated in the blue light-emitting unit of FIG. 2, and FIG. 4 illustrates a light-emitting region provided in the blue light-emitting unit of FIG. 2.

As shown in FIG. 1, the light-emitting device according to the first embodiment of the present disclosure includes a first electrode 110 and a second electrode 200 facing each other, and a first blue stack BS1, a first charge generation layer CGL, and a phosphorescent stack PS between the first electrode 110 and the second electrode 200.

The light-emitting device of the present disclosure includes a plurality of stacks between the first and second electrodes 110 and 200, and emits white light by combination of colors of light emitted from the plurality of stacks. White light can be realized by combination of the first blue stack BS1 with the phosphorescent stack PS shown in FIG. 1 as a minimal configuration of the light-emitting device. When the light-emitting device has a minimal stack configuration, the phosphorescent stack PS may contact the second electrode 200.

The light-emitting device may further include an additional stack between the phosphorescent stack PS and the second electrode 200, between the first electrode 110 and the second electrode 200, to express more diverse colors. The additional stack may be a second blue stack that is different from or the same as that of the first blue stack BS1, or a stack emitting light with other color.

Here, one of the first electrode 110 and the second electrode 200 may be an anode and the other may be a cathode. When the light-emitting device is applied to a light-emitting display device, the first electrode 110 may be disposed close to the substrate, or the second electrode 110 may be disposed close to the substrate in an inverted form of the structure shown in FIG. 1. One of the first and second electrodes 110 and 200 may be a reflective electrode and the other may be a transparent electrode or a reflective and transmissive electrode. The reflective electrode is, for example, at least one metal selected from Al, Ag, and Mg, or an alloy containing at least one of Al, Ag, and Mg. The reflective and transmissive electrode may include a metal of the same type as that of the reflective electrode and have a small thickness of 200Å or less, allowing light having a microcavity characteristic to be transmitted. Examples of the transparent electrode include indium tin oxide (ITO), indium zinc oxide (IZO), indium tin zinc oxide (ITZO) and the like.

The first blue stack BS1 comes into contact with the first electrode 110 and includes a first blue light-emitting unit BEM at the center, a first common layer CML1 in a lower part and a second common layer CML2 in an upper part.

The first common layer CML1 is a layer related to hole injection and generation, and may include a hole injection layer, a hole transport layer, and an electron blocking layer.

The second common layer CML2 is a layer related to electron transport and control, and may include an electron transport layer.

The phosphorescent stack PS may include at least one phosphorescent light-emitting layer PEML, and may include a third common layer CML3 and a fourth common layer CML4 in a lower portion and an upper portion, respectively.

The third common layer CML3 is a layer related to hole generation and may include a hole transport layer and an electron blocking layer.

The fourth common layer CML4 is a layer related to electron transport and control, and may include an electron transport layer. When the light-emitting device includes only two stacks of the first blue stack BS1 and the phosphorescent stack PS, the fourth common layer CML4 may include an electron injection layer as a layer in contact with the second electrode 200.

More specifically, as shown in FIGS. 2 to 4, the first blue stack BS1 includes a hole transport layer (HTL) 1230, a first blue light-emitting layer (BEML1) 1241, a second blue light-emitting layer (BEML2) 1242, and an electron transport layer (ETL) 1240 in this order. That is, the first blue light-emitting layer 1241 and the second blue light-emitting layer 1242 constitute the blue light-emitting unit BEM, and both layers can emit blue light.

In the following description, the hole transport layer 1230 in contact with the first blue light-emitting layer 1241 is a layer related to hole transport. The hole transport layer 1230 may be a known arylene-based hole transport layer. In the light-emitting device of the present disclosure, the hole transport layer 1230 is formed using a material having a higher Lowest Unoccupied Molecular Orbital (LUMO) energy level HTL_LUMO than the LUMO energy level (BH LUMO) of the host BH provided in the blue light-emitting unit BEM to prevent electrons from moving from the adjacent blue light-emitting unit BEM. In consideration thereof, the hole transport layer 1230 in contact with the first blue light-emitting layer 1241 is also referred to as an "electron blocking layer" (EBL). In some cases, the hole transport layer may have a multilayered structure in which a hole transport layer such as an arylene-based NPD is disposed on the side far from the first blue light-emitting layer 1241, and an electron blocking layer such as TAPC is disposed on the side in contact with the first blue light-emitting layer 1241.

Meanwhile, the hole transport layer 1230 of the present disclosure may function to transport holes and to block electrons, which is possible based on the difference in energy band gap with the adjacent first blue light-emitting layer 1241 and the material therefor is not limited to those described above.

The first and second blue light-emitting layers 1241 and 1242 include the same host BH and include different first and second blue dopants BD1 and BD2, respectively. As shown in FIG. 2, the HOMO energy level BD1_HOMO of the blue dopant BD1 is higher than the highest occupied molecular orbital (HOMO) energy level HTL_HOMO of the hole transport layer 1230. The first blue dopant BD1 in the first blue light-emitting layer 1241 has a higher HOMO energy level (BD1_HOMO) than the HOMO energy level (HTL HOMO) of the hole transport layer 1230, and thus can trap the holes transported from the hole transport layer 1230, and the holes trapped by the first blue dopant BD1 can react with electrons transported from the second blue light-emitting layer 1242 rather than being used to generate excitons to cause auxiliary light emission.

In this case, FIG. 3 shows that auxiliary light emission occurs in the first blue light-emitting layer 1241, whereas main light emission occurs at the interface between the first and second blue light-emitting layers 1241 and 1242. This is because light emission of the blue light-emitting unit BEM does not occur at the same intensity at the centers of the first and second blue light-emitting layers 1241 and 1242, but main light emission caused by the host is concentrated at the interface between the first and second blue light-emitting layers 1241 and 1242, as shown in FIG. 4, since the blue light-emitting layers 1241 and 1242 have a common host BH. Also, auxiliary light emission caused by the hole trapping property of the first blue dopant BD1 in the region of the first blue light-emitting layer 1241 weakly occurs overall in proportion to the dopant content in the first blue light-emitting layer 1241. Accordingly, as shown in FIG. 4, in the first blue light-emitting layer 1241, since auxiliary light emission caused by the first blue dopant BD1 is generated along with main light emission, intensity of which gradually decreases as it moves away from the center of the first and second blue light-emitting layers 1241 and 1242, light emission that gradually decreases towards the hole transport layer 1230 is generated as a whole.

That is, as shown in FIG. 4, in the blue light-emitting unit BEM including the first and second blue light-emitting layers 1241 and 1242 that are in contact with each other, an asymmetric distribution of the hole trap region biased toward the first blue light-emitting layer 1241 is generated, and the first blue light-emitting layer 1241 can be completely used for light emission based on such asymmetric distribution compared to a mode in which light is concentrated only on a specific region when a single blue dopant is used. In addition, by lowering the hole transport speed of the hole transport layer compared to the electron speed of the electron transport layer, the exciton formation region can be widened and thus the lifespan of the light-emitting device can be improved. Accordingly, asymmetric light emission between the first blue light-emitting layer 1241 and the second blue light-emitting layer 1242 occurs in the blue light-emitting unit BEM. That is, since the entire area of the first blue light-emitting layer 1241 is used as the light-emitting region, the second blue light-emitting layer 1242 emits light with the highest intensity at the interface between the second blue light-emitting layer 1242 and the first blue light-emitting layer 1241. Here, the second blue light-emitting layer 1242 may have a region not emitting light immediately adjacent to the electron transport layer (ETL) 1250 due to the speed at which electrons are transported adjacent to the electron transport layer 1250.

The content of the first and second blue dopants BD1 and BD2 in the entire blue light-emitting unit BEM is 0.1 wt% to 10 wt%, which is very low, corresponding to 1/1000 to 1/10 of that of the host. Accordingly, most of the holes transported through the hole transport layer 1230 and the electrons transported through the electron transport layer 1250 based on the blue light-emitting unit BEM are moved through the host BH, which is the main component of the blue light-emitting unit BEM and main light emission is concentrated at the interface between the first and second blue light-emitting layers 1241 and 1242. In this case, since the host BH is present in the entire blue light-emitting unit BEM, and holes and electrons move to the center of the blue light-emitting unit BEM through the host due to the driving current generated by a voltage difference applied between the first and second electrodes 110 and 200, the main light emission may be stronger at the center, but may be weaker as the distance from the center is increased.

In addition, the first blue dopant BD1 of the first blue light-emitting layer 1241 has a hole trapping property due to the higher HOMO energy level compared to the adjacent hole transport layer 1230 and thus traps some holes transported from the hole transport layer before recombination with electrons inside the blue light-emitting unit (BEM), and auxiliary light emission is generated by combination of electrons not used for exciton formation with holes trapped by the first blue dopant BD1 in the second blue light-emitting layer 1242. As the first blue dopant BD1 is doped in an amount of 0.1 wt% to 10 wt% in the entire first blue light-emitting layer 1241, auxiliary light emission may be generated in the entire first blue light-emitting layer 1241, but may be weaker than the main light emission due to the difference in the content of the first blue dopant BD1.

However, the light-emitting device of the present disclosure has an advantage of having an increased light-emitting region compared to the narrow emission area due to the concentration of light emission at the center of the single blue light-emitting layer or the interface between the single blue light-emitting layer and the hole transport layer by utilizing holes trapped by the first blue dopant BD1 in the entire first blue light-emitting layer 1241 and electrons not used in main light emission through the host. In addition, when the electron transport layer 1250 transports electrons to the blue light-emitting unit (BEM) at a high speed due to excellent electron transport ability thereof, and the speed at which holes are transported to the hole transport layer 1230 does not reach the speed of the electrons, electrons not used for light emission through excitation may enter the hole transport layer 1230. The light-emitting device is capable of preventing this phenomenon and uses such electrons for auxiliary light emission in the first blue light-emitting layer 1241, thereby increasing recombination between electrons and holes to improve external quantum efficiency, and preventing accumulation of electrons or excitons at the interface between the blue light-emitting unit (BEM) or the hole transport layer 1230 to improve lifespan.

Meanwhile, the hole transport layer 1230 in contact with the first blue light-emitting layer 1241 has the function to prevent electrons (excitons) from passing through the blue light-emitting unit BEM, in addition to the function to transport holes to the blue light-emitting unit BEM. To this end, the lowest unoccupied molecular orbital (LUMO) energy level (HTL_LUMO) of the hole transport layer 1230 in contact with the first blue light-emitting layer 1241 is preferably higher than the LUMO energy level of the first blue light-emitting layer 1241.

The first and second blue dopants BD1 and BD2 in the blue light-emitting unit BEM fall from the LUMO energy level to the HOMO energy level. At this time, excitons are generated. The difference between the LUMO energy level and the HOMO energy level of the first and second blue dopants BD1 and BD2 corresponds to a band gap, and each material has a band gap of about 2.7 eV to 3.0 eV in order to occur (e.g. cause) blue light emission from the blue light-emitting unit BEM.

For the hole trapping of the first blue dopant BD1 in the first blue light-emitting layer 1241, the HOMO energy level BD1_HOMO of the first blue dopant BD1 is preferably at least 0.1 eV higher than the HOMO energy level HTL_HOMO of the hole transport layer 1230. In order to effectively trap holes transported from the hole transport layer 1230 at the HOMO energy level of the first blue dopant BD1 in the first blue light-emitting layer 1241, the HOMO energy level BD1_HOMO of the first blue dopant BD1 preferably has a difference of 1 eV or less from the HOMO energy level (HTL_HOMO) of the hole transport layer 1230. That is, when the HOMO energy level BD1_HOMO of the first blue dopant BD1 is higher than the HOMO energy level HTL_HOMO of the hole transport layer 1230 by more than 1.0 eV, hole trapping may not be effectively generated, i.e. hole trapping may be effectively suppressed.

In addition, the HOMO energy level HTL_HOMO of the hole transport layer 120 must be higher than the HOMO energy level of the blue light-emitting unit BEM in order to realize hole transport from the hole transport layer 1230 to the blue light-emitting unit BEM. That is, the relationship between the HOMO energy levels of the materials at the interface between the hole transport layer 1230 and the blue light-emitting unit BEM is as follows: BD1_HOMO>HTL_HOMO>BH_HOMO.

Accordingly, the HOMO energy level BD1_HOMO of the first blue dopant BD1 is preferably at least 0.5 eV higher than the HOMO energy level BH_HOMO of the host BH used in the blue light-emitting unit BEM.

For example, when the HOMO energy level HTL_HOMO of the hole transport layer 1230 is -5.5 eV to -5.9 eV, the HOMO energy level BD1_HOMO of the first blue dopant BD1 of the first blue light-emitting layer 1241 may correspond to -5.0 eV to -5.4 eV. In this case, the HOMO energy level (BH_HOMO) of the host may be -5.9 eV to -6.3 eV.

Meanwhile, the blue host BH may be a single material or include a plurality of materials. In the light-emitting device of the present disclosure, the first and second blue light-emitting layers 1241 and 1242 are commonly used. In addition, the blue host BH has a larger energy bandgap than the first and second blue dopants BD1 and BD2 in order to transfer energy to the first and second blue dopants BD1 and BD2, and uses a material having an energy bandgap of 3.0 eV or higher.

The blue host (BH) may be any one of an anthracene-based compound, a fluorene-based compound, and a pyrene-based compound. In some cases, the blue host (BH) may further include an arylene-based compound for other transport properties.

Each of the first and second blue dopants BD1 and BD2 has an emission peak at 440 nm to 470 nm and each or one thereof may use a boron-based compound or a pyrene-based compound.

For example, the second blue dopant BD2 of the second blue light-emitting layer 1242 may include any one of the materials represented by the following Formulas 1 to 9.

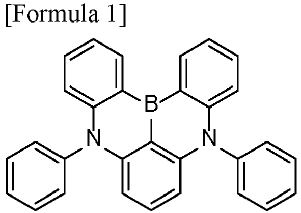

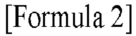

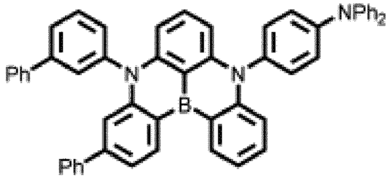

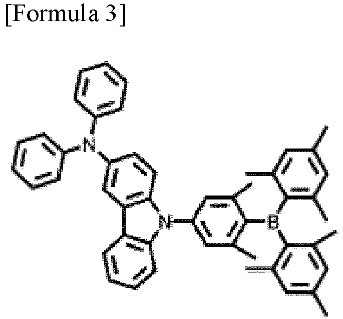

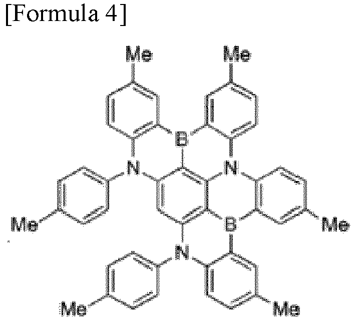

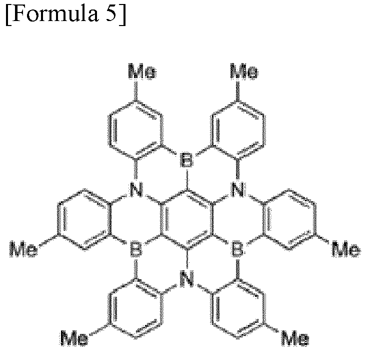

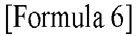

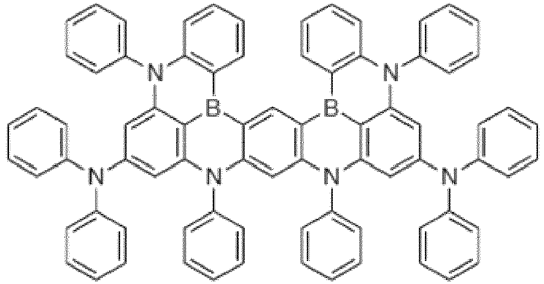

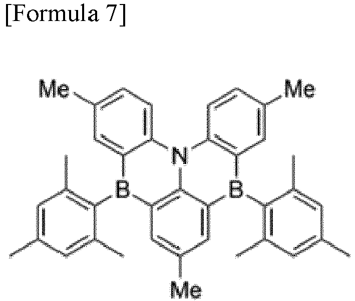

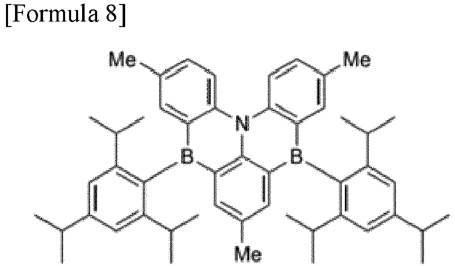

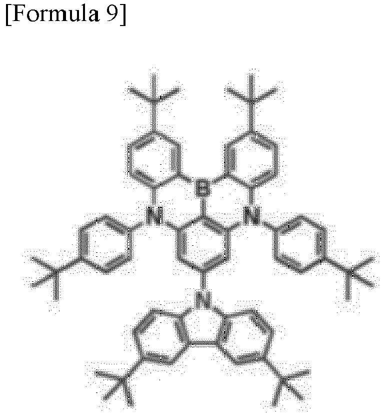

In addition, for example, the first blue dopant BD1 of the first blue light-emitting layer 1241 is formed by substituting an end group of any one of the compounds represented by Formulas 1 to 9 by carbazole of Formula 10, acridine of Formula 11, diphenylamine of Formula 12, or dibenzofuran of Formula 13 in order for the first dopant BD1 to have a higher HOMO energy level than the HOMO energy level of the second blue dopant BD2, as follows.

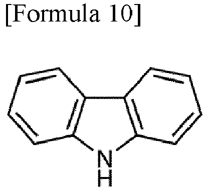

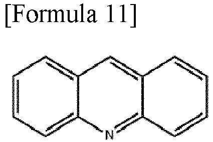

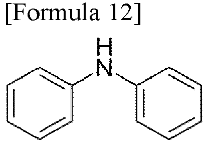

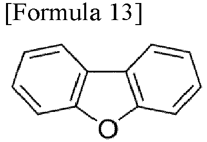

Hereinafter, experiments for evaluating the properties of the first and second blue dopants used in the first and second blue light-emitting layers of the light-emitting device of the present disclosure will be described.

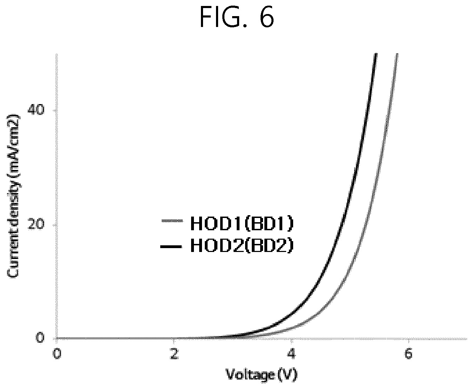

FIG. 5 is an energy band diagram of a hole-only device (HO device, HOD) to determine the I-V characteristics of the first and second blue dopants, and illustrates carrier movement in the HO device. FIG. 6 is a graph illustrating the I-V characteristics of the first and second blue dopants, measured through the HOD of FIG. 5. FIG. 5 illustrates a light-emitting region when a single dopant is applied to a blue light-emitting unit.

In order to determine the hole-related characteristics of the first and second blue dopants BD1 and BD2, as shown in FIG. 5, a device only including a hole transport layer HTL and a blue light-emitting layer B EML between an anode and a cathode is formed.

In addition, the blue light-emitting layer B EML includes a common anthracene-based compound, the first blue dopant BD1 is doped at an equal amount of 2 wt% in the first HO device HOD1, and the second blue dopant BD2 is doped at an equal amount of 2 wt% in the second HO device HOD2.

As shown in FIG. 6, in view of the driving voltage versus current in each of the first and second HO devices HOD1 and HOD2, the graph of the first HO device HOD1 compared to the second HO device HOD2 shows a J-V shift. This is because the first blue dopant BD1 of the first HO device HOD1 has a hole trapping property compared to the second blue dopant BD2.

Meanwhile, the second blue dopant BD2 used in the second HO device HOD2 has relatively excellent J-V characteristics.

However, when a single dopant is used as the second blue dopant BD2 to form a single blue light-emitting layer, holes and electrons supplied from the hole transport layer HTL and the electron transport layer ETL, respectively, recombine with each other in a narrow light-emitting region in the blue light-emitting layer, to emit light. In this case, narrow light-emitting characteristics are obtained.

Accordingly, in the light-emitting device of the present disclosure, as described with reference to FIGS. 1 to 4, the blue light-emitting unit has a structure of two layers including dopants having different properties from each other, thus widening the distribution of the light-emitting region of the blue light-emitting unit. The main light emission may be achieved by carrier transport using a host in the entire blue light-emitting unit. In addition, the first blue light-emitting layer in contact with the hole transport layer (or electron blocking layer) is doped with a first blue dopant having a higher HOMO energy level than the HOMO energy level of the adjacent hole transport layer (or electron blocking layer), and thus the first blue dopant can trap the holes transported from the hole transport layer (or electron blocking layer). In addition, auxiliary light emission is generated by recombination of the electrons transported without being used for excitation in the second blue light-emitting unit with the holes trapped in the first blue dopant. The auxiliary light emission enables the light-emitting region in the first blue light-emitting layer to be wide enough to be adjacent to the hole transport layer (or electron blocking layer) even when an electron transport layer having high transport capacity is used, increases the recombination rate of carriers in the blue light-emitting unit and thus improves the external quantum efficiency.

In addition, the light-emitting device of the present disclosure improves luminous efficacy due to the increased exciton generation rate in the blue light-emitting layer, prevents electrons from being accumulated in the hole transport layer or electron blocking layer beyond the light-emitting layer, and thereby improves the lifespan of the light-emitting device. In addition, the light-emitting device and a light-emitting display device including the same are capable of improving the lifespan by reducing a factor causing extinction in the blue light-emitting unit.

Various embodiments of the present disclosure will be described.

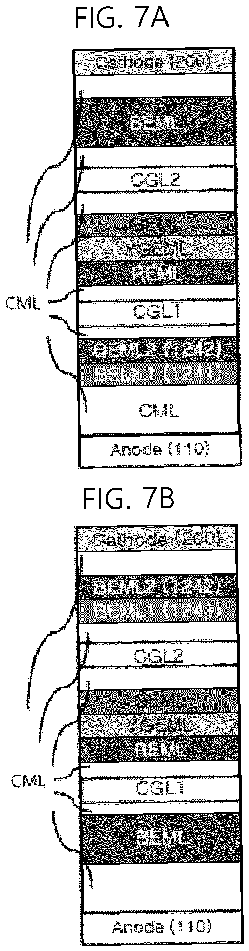

FIGS. 7A to 7C are cross-sectional views of light-emitting devices according to second to fourth embodiments of the present disclosure.

FIGS. 7A to 7C illustrate an example in which a light-emitting device is implemented in a three-stack structure.

As shown in FIGS. 7A to 7C, the stacks of the light-emitting device are separated by charge generation layers CGL1 and CGL2, a phosphorescent stack including a red light-emitting layer (REML), a yellow green light-emitting layer (YGEML) and a green light-emitting layer (GEML) is disposed in the center and other stacks contacting the anode 110 and the cathode 200 are disposed as blue light-emitting stacks.

As shown in FIG. 7A, the light-emitting device according to the second embodiment of the present disclosure includes a blue light-emitting unit of a first blue light-emitting stack in contact with the anode 110 as a double layer structure including first and second blue light-emitting layers 1241 and 1242, and a blue light-emitting unit of a second blue light-emitting stack in contact with the cathode 200 as a single blue light-emitting layer (BEML) structure.

Each first blue light-emitting layer 1241 includes the blue host BH and the first blue dopant BD1 having hole trapping properties described with reference to FIGS. 1 to 4, and the second blue light-emitting layer 1242 and the single-layer blue light-emitting layer BEML include the second blue dopant BD2 having no hole trapping property.

As shown in FIG. 7B, the light-emitting device according to the third embodiment of the present disclosure includes the blue light-emitting unit of the second blue light-emitting stack in contact with the cathode 200 as a double layer structure including first and second blue light-emitting layers 1241 and 1242, and the blue light-emitting unit of the first blue light-emitting stack in contact with the anode 110 as a single blue light-emitting layer (BEML).

Each first blue light-emitting layer 1241 includes the blue host BH and the first blue dopant BD1 having hole trapping properties described with reference to FIGS. 1 to 4, and the second blue light-emitting layer 1242 and the single-layer blue light-emitting layer BEML use the second blue dopant BD2 having no hole trapping property.

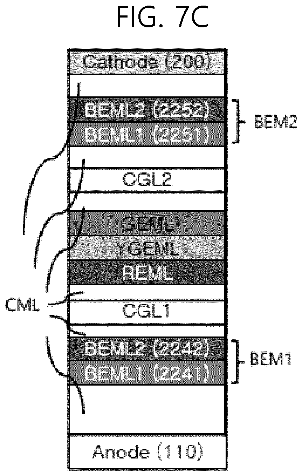

As shown in FIG. 7C, the light-emitting device according to the fourth embodiment of the present disclosure includes the first blue light-emitting unit BEM1 of the first blue light-emitting stack in contact with the anode 110 as a double layer structure including first and second blue light-emitting layers 2241 and 2242, and the second blue light-emitting unit BEM2 of the second blue light-emitting stack in contact with the cathode 200 as a double layer structure including third and fourth blue light-emitting layers 2251 and 2252.

Each of the first blue light-emitting layer 2241 and the third blue light-emitting layer 2251 includes the blue host BH and the first blue dopant BD1 having hole trapping properties described with reference to FIGS. 1 to 4, and the second blue light-emitting layer 2242 and the fourth blue light-emitting layer 2252 use the second blue dopant BD2 having no hole trapping property.

Meanwhile, a common layer (CML) is provided between the electrode and the light-emitting layer or between the light-emitting layer and the charge generation layer of each stack described above, a common layer close to the anode 110 based on the light-emitting layer is a common layer related to hole transport, and a common layer close to the cathode 200 based on the light-emitting layer is a common layer related to electron transport.

**[Table 1]**

| Item | | First experimental embodiment (Ex1) | Second embodiment | Third embodiment | Fourth embodiment |
|---|---|---|---|---|---|
| BEM2 | | BEML (wBD2) | BEML (wBD2) | BEML1:BEML2 | BEML3:BEML4 |
| BEM1 | | BEML (wBD2) | BEML1:BEML2 | BEML(w BD2) | BEML1:BEML2 |
| Efficency | R | 100% | 104% | 106% | 100% |
| | G | 100% | 98% | 100% | 102% |
| | B | 100% | 101% | 102% | 101% |
| | W | 100% | 100% | 101% | 101% |
| T95 lifespan | B | 100% | 117% | 115% | 135% |

Table 1 shows the efficiency and T95 lifespan when the first blue light-emitting unit of the first blue stack and the second blue light-emitting unit of the second blue stack that come into contact with the anode and the cathode in a three-stack structure have a single- or double-layered structure.

The efficiency for each color and the T95 lifespan of the first experimental embodiment (Ex1) in which both the first and second blue light-emitting units have a single layer, that is, in which a single blue light-emitting layer including the second blue dopant BD2 as a dopant is formed, are compared with those of the second to fourth embodiments.

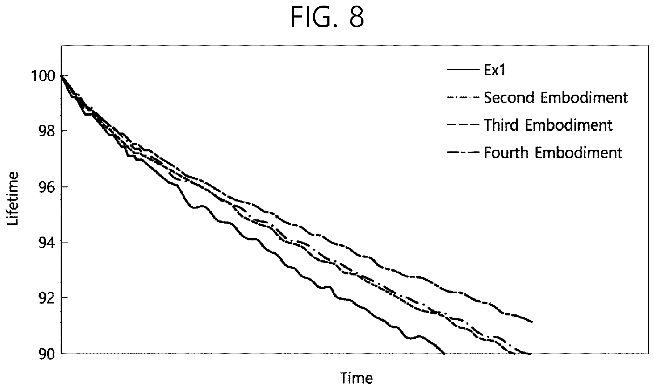

FIG. 8 is a graph showing the blue lifespan of the first experimental embodiment and the second to fourth embodiments.

As shown in FIG. 8 and Table 1, the T95 lifespan is improved in the order of the first experimental embodiment (Ex1), the third embodiment, the second embodiment, and the fourth embodiment, and a structure having more double-layered blue light-emitting units has an effect of further improving the lifespan. Although the difference in lifespan between the third embodiment and the second embodiment is about 2%, both the second and third embodiments have an effect of improving lifespan by 15% or more compared to the first experimental embodiment (Ex1).

Meanwhile, as can be seen from Table 1, all of red, green, blue, and white efficiencies are improved or have the same level in the second to fourth embodiments.

Therefore, it can be seen from the above experiment that both lifespan and efficiency can be improved when the light-emitting device of the present disclosure is applied.

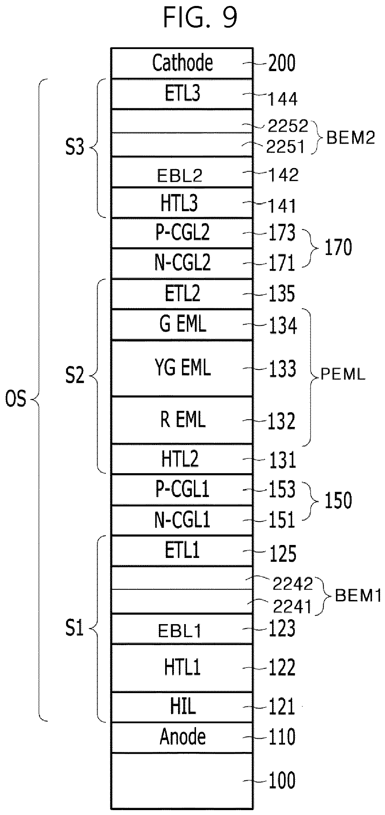

FIG. 9 is a cross-sectional view illustrating a specific example of FIG. 7C.

FIG. 9 shows an example in which the light-emitting device according to an embodiment of the present disclosure has three stacks S1, S2, and S3 between the anode 110 and the cathode 200. Here, the first to third stacks S1, S2, and S3 are separated by the first and second charge generation layers 150 and 170. The first stack S1 includes a hole injection layer (HIL) 121, a first hole transport layer (HTL1) 122, an electron blocking layer (EBL1) 123, a first blue light-emitting unit BEM1 including first and second blue light-emitting layers 2241, 2242 described with reference to FIGS. 1 to 4, and a first electron transport layer (ETL1) 125 sequentially stacked between the anode 110 and the first charge generation layer 150. The first blue light-emitting layer 2241 includes a first blue dopant BD1 having a hole trapping property, and the second blue light-emitting layer 2242 includes a second blue dopant BD2 that does not have a hole trapping property and receives energy from a host BH to induce main light emission.

The second stack S2 is provided between the first and second charge generation layers 150 and 170, and includes a phosphorescent light-emitting layer (PEML) including a red light-emitting layer (R EML) 132, a yellow-green light-emitting layer (YG EML) 133, and a green light-emitting layer (G EML) 134 stacked adjacent to one another, a second hole transport layer (HTL2) 131 under the red light-emitting layer 132, and a second electron transport layer (ETL2) 135 on the green light-emitting layer 134.

The third stack S3 is provided between the second charge generation layer 170 and the cathode 200, and includes a third hole transport layer (HTL3) 141, a second electron blocking layer (EBL2) 142, a second blue light-emitting unit BEM2 including third and fourth blue light-emitting layers 2251 and 2252, and a third electron transport layer (ETL3) 144 sequentially stacked. The third blue light-emitting layer 2251 includes a first blue dopant BD1 having a hole trapping property, and the fourth blue light-emitting layer 2252 includes a second blue dopant BD2 that does not have a hole trapping property and receives energy from the host BH to induce main light emission.

In addition, the cathode 200 may be formed on the third electron transport layer (ETL3) 144. In some cases, an electron injection layer may be further formed between the third electron transport layer (ETL3) 144 and the cathode 200.

The first and second charge generation layers 150 and 170 between the stacks include n-type charge generation layers (N-CGL1, N-CGL2) 151 and 171 functioning to generate electrons and transfer the electrons to adjacent stacks, and p-type charge generation layers (P-CGL1, P-CGL2) 153 and 173 functioning to generate holes and transfer the holes to adjacent stacks. In some cases, the first and second charge generation layers 150 and 170 may be formed as a single layer by doping at least one host with a combination of an n-type dopant and a p-type dopant.

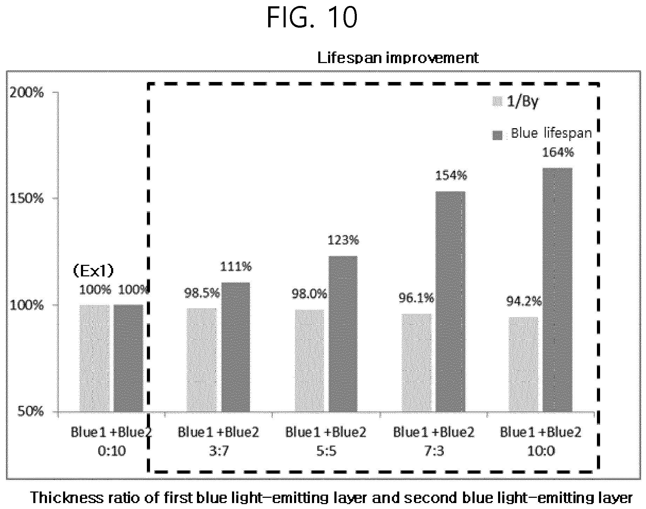

As described above, in the light-emitting device according to FIG. 10, main light emission is generated at the interface between the first and second blue light-emitting layers 2241 and 2242 due to the movement of the main carriers of the host in the first blue light-emitting unit BEM1, and auxiliary light emission is generated by recombination of electrons and holes transported to the first blue light-emitting layer 2241 through the first hole transport layer 122 and the first electron blocking layer 123 by hole trapping in the first blue dopant BD1 of the first blue light-emitting layer 2241, so light emission can be generated as a combination of main light emission with auxiliary light emission in the entire area of the first blue light-emitting layer 2241 and a light-emitting region, in which the second blue light-emitting layer 2242 has the highest luminous efficacy at the interface between the first and second blue light-emitting layers 2241 and 2242 and gradually decreases in luminous efficacy toward the first electron transport layer 125, the light-emitting region may be widened.

Similarly, main light emission is generated at the interface between the third and fourth blue light-emitting layers 2251 and 2252 due to the movement of the main carriers of the host in the second blue light-emitting unit BEM2, and auxiliary light emission is generated by recombination of electrons and holes transported to the third blue light-emitting layer 2251 through the third hole transport layer 141 and the second electron blocking layer 142 by hole trapping in the first blue dopant BD1 of the third blue light-emitting layer 2251, so light emission can be generated as a combination of main light emission with auxiliary light emission in the entire area of the third blue light-emitting layer 2551 and a light-emitting region, in which the fourth blue light-emitting layer 2252 has the highest luminous efficacy at the interface between the third and fourth blue light-emitting layers 2251 and 2252 and gradually decreases in luminous efficiency toward the third electron transport layer 144, the light-emitting region may be widened.

FIG. 10 is a graph showing the 1/By characteristics and lifespan depending on the thickness ratio of the first and second blue light-emitting layers 2241, 2242 in the blue light-emitting unit in the light-emitting device of the present disclosure.

As can be seen from FIG. 10, when the thickness ratio of the first blue light-emitting layer BEML1 (blue 1) is increased, the lifespan is improved. That is, even when the light-emitting device includes only the first blue light-emitting layer BEML1 having a hole trapping property along with the second blue light-emitting layer BEML2 that causes main light emission, the lifespan is improved.

Meanwhile, it can be seen that the characteristic of 1/By indicating blue efficiency decreases as the thickness of the first blue light-emitting layer BEML1 increases.

Compared to the first experimental embodiment (Ex1), a normal level of the 1/By characteristic is 95% or more and the 1/By characteristic is within a normal level when the thickness ratio of the first blue light-emitting layer BEML1 to the second blue light-emitting layer BEML2 is up to about 9:1.

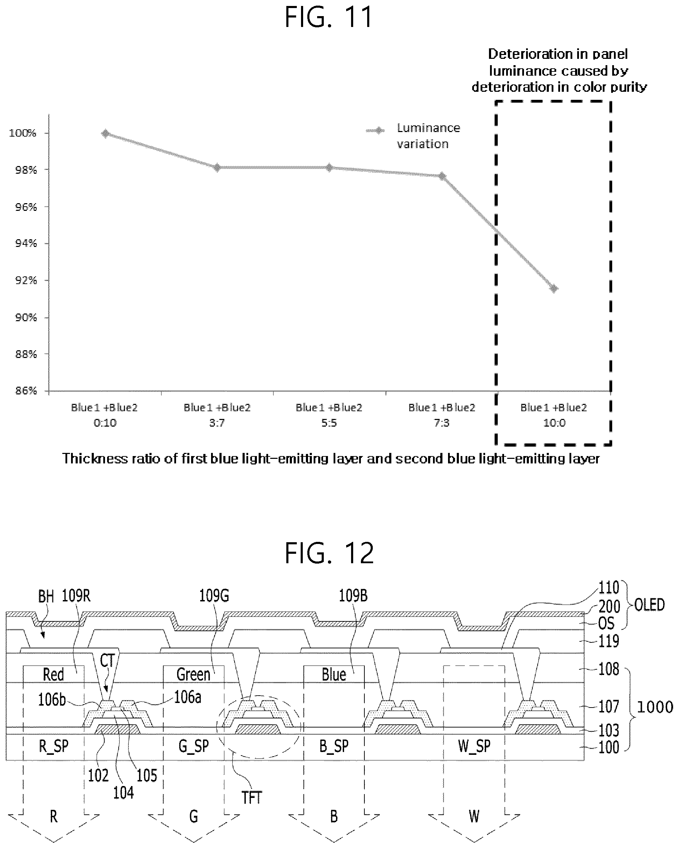

FIG. 11 is a graph illustrating luminance generated depending on the thickness ratio of first and second blue light-emitting layers in a blue light-emitting unit in the light-emitting device of the present disclosure.

FIG. 11 shows the result of testing on panel luminance as a function of the 1/By value.

That is, as the thickness ratio of the first and second blue light-emitting layers BEML1 and BEML2 varies from 7:3 to 10:0, luminance decreases linearly. The luminance is approximately 95% up to the thickness ratio of 8:2. When the thickness ratio of the first and second blue light-emitting layers BEML1 and BEML2 in the light-emitting device of the present disclosure falls within the range from 1:8 to 8:2, both lifespan and panel efficiency are improved to normal levels or higher.

Meanwhile, the number of stacks of the light-emitting device of the present disclosure is not limited to two or three and may be four or more. For example, in the structure of FIG. 10, an additional stack may be provided between the third stack S3 and the cathode 200. In this case, the additional stack has the same structure as the blue stack described with reference to FIGS. 1 to 4.

Hereinafter, a light-emitting display device using the light-emitting device according to the present disclosure will be described.

FIG. 12 is a sectional view illustrating the light-emitting display device using the light-emitting device according to the present disclosure.

Meanwhile, the light-emitting device may be commonly applied to a plurality of subpixels to emit white light to a light-emitting electrode.

As shown in FIG. 12, the light-emitting display device of the present disclosure includes a substrate 100 having a plurality of subpixels R_SP, G_SP, B_SP, and W_SP, a light-emitting device (also referred to as an "OLED, organic light-emitting diode") commonly provided on the substrate 100, a plurality of thin film transistors (TFT) respectively provided in the subpixels and connected to the first electrode 110 of the light-emitting device (OLED), and a color filter layer 109R, 109G, or 109B provided below the first electrode 110 of at least one of the subpixels.

The illustrated example relates to a configuration including the white subpixel W_SP, but the present disclosure is not limited thereto. A configuration in which the white subpixel W_SP is omitted and only the red, green, and blue subpixels R_SP, G_SP, and B_SP are provided is also possible. In some cases, a combination of a cyan subpixel, a magenta subpixel, and a yellow subpixel capable of creating white may be used instead of the red, green, and blue subpixels.

The thin film transistor TFT includes, for example, a gate electrode 102 and a semiconductor layer 104, and a source electrode 106a and a drain electrode 106b connected to respective sides of the semiconductor layer 104. In addition, a channel passivation layer 105 may be further provided on the portion where the channel of the semiconductor layer 104 is located in order to prevent direct connection between the source/drain electrodes 106a and 106b and the semiconductor layer 104.

A gate insulating layer 103 is provided between the gate electrode 102 and the semiconductor layer 104.

The semiconductor layer 104 may be formed of, for example, an oxide semiconductor, amorphous silicon, polycrystalline silicon, or a combination thereof. For example, when the semiconductor layer 104 is an oxide semiconductor, the heating temperature required to form the thin film transistor can be lowered, and thus the substrate 100 can be selected from among a greater variety of available types thereof, so the semiconductor layer 104 can be advantageously applied to a flexible display.

In addition, the drain electrode 106b of the thin film transistor TFT may be connected to the first electrode 110 in a contact hole CT formed in the first and second passivation layers 107 and 108.

The first passivation layer 107 is provided to primarily protect the thin film transistor TFT, and color filters 109R, 109G, and 109B may be provided thereon.

When the plurality of subpixels includes a red subpixel, a green subpixel, a blue subpixel, and a white subpixel, the color filter may include first to third color filters in each of the remaining subpixels 109R, 109G, and 109B, excluding the white subpixel W_SP, and may allow the emitted white light to pass through the anode 110 for each wavelength. A second passivation layer 108 is formed under the anode 110 to overlay the first to third color filters 109R, 109G, and 109B. The anode 110 is formed on the surface of the second passivation layer 108, excluding the contact hole CT.

Here, the configuration including the substrate 100, the thin film transistor TFT, color filters 109R, 109G, and 109B, and the first and second passivation layers 107 and 108 is referred to as a "thin film transistor array substrate 1000".

The light-emitting device OLED is formed on the thin film transistor array substrate 1000 including a bank 119 defining a light-emitting unit BEM. The light-emitting device (OLED), for example, includes a transparent anode 110, a cathode 200 of a reflective electrode facing the anode 110, and an electron transporting and blocking unit (ETBU) including an electron blocking layer 123 including an electron blocking material represented by Formula 2, a blue light-emitting layer 124 including a boron-based blue dopant, and an electron transporting layer 125 including an electron transporting material represented by Formula 1 in blue light-emitting stacks S1 and S3 among stacks divided by the first and second charge generation layers CGL1 and CGL2, between the anode 110 and the cathode 200, as described with reference to FIGS. 1A to 2 and 5.

The anode 110 is divided for each subpixel, and the remaining layers of the white-light-emitting device OLED are integrally provided in the entire display area, rather than being divided into individual subpixels.

Meanwhile, the light-emitting device OLED including an internal stack OS between the anode 110 and the cathode 200 may include the structure of the light-emitting device described with reference to FIGS. 1 to 4, or the structure of the light-emitting device used in FIG. 10.

The light-emitting device and the light-emitting display device including the same according to the present disclosure have the following effects.

The blue light-emitting unit has a structure of two layers including dopants having different properties from each other, thus widening the distribution of the light-emitting region of the blue light-emitting unit. The main light emission may be achieved by carrier transport using a host in the entire blue light-emitting unit. In addition, the first blue light-emitting layer in contact with the hole transport layer (or electron blocking layer) is doped with a first blue dopant having a higher HOMO energy level than the HOMO energy level of the adjacent hole transport layer (or electron blocking layer), and thus the first blue dopant can trap the holes transported from the hole transport layer (or electron blocking layer). In addition, auxiliary light emission is generated by recombination of the electrons transported without being used for excitation in the second blue light-emitting unit with the holes trapped in the first blue dopant. The auxiliary light emission enables the light-emitting region in the first blue light-emitting layer to be wide enough to be adjacent to the hole transport layer (or electron blocking layer) even when an electron transport layer having high transport capacity is used, increases the recombination rate of carriers in the blue light-emitting unit and thus improves the external quantum efficiency.

In addition, the light-emitting device of the present disclosure improves luminous efficacy due to the increased exciton generation rate in the blue light-emitting layer, prevents electrons from being accumulated in the hole transport layer or electron blocking layer beyond the light-emitting layer, and thereby improves the lifespan of the light-emitting device. In addition, the light-emitting device and a light-emitting display device including the same are capable of improving the lifespan by reducing a factor causing extinction in the blue light-emitting unit.

A light-emitting device according to one aspect of the present disclosure may comprise a first electrode and a second electrode facing each other over a substrate and a first blue stack, a first charge generation layer, and a phosphorescent stack between the first electrode and the second electrode. The first blue stack may sequentially comprise a hole transport layer, a first blue light-emitting layer, a second blue light-emitting layer, and an electron transport layer, the first and second blue light-emitting layers may comprise the same host BH and may comprise different first and second blue dopants, respectively, and the first blue dopant has a higher HOMO energy level than a HOMO energy level of the hole transport layer.

In a light-emitting device according to one aspect of the present disclosure, the HOMO energy level of the hole transport layer may be between a HOMO energy level of the host and the HOMO energy level of the first blue dopant.

In a light-emitting device according to one aspect of the present disclosure, the HOMO energy level of the first blue dopant may be at least 0.1 eV higher than the HOMO energy level of the hole transport layer, and the HOMO energy level of the host may be at least 0.5 eV lower than the HOMO energy level of the first blue dopant.

In a light-emitting device according to one aspect of the present disclosure, a thickness ratio of the first blue light-emitting layer to the second blue light-emitting layer may be 1:8 to 8:2.

In a light-emitting device according to one aspect of the present disclosure, the phosphorescent stack may comprise a red light-emitting layer, a yellow-green light-emitting layer and a green light-emitting layer adjacent to the first charge generation layer.

A light-emitting device according to one aspect of the present disclosure, may further comprise at least one second blue stack between the phosphorescent stack and the second electrode.

In a light-emitting device according to one aspect of the present disclosure, the second blue stack may sequentially comprise the same hole transport layer, the same first blue light-emitting layer, the same second blue light-emitting layer, and the same electron transport layer as those of the first blue stack.

In a light-emitting device according to one aspect of the present disclosure, each of the first blue light-emitting layer and the second blue light-emitting layer may have an emission peak of 440 nm to 470 nm.

In a light-emitting device according to one aspect of the present disclosure, the first blue dopant may be present in an amount of 0.1 wt% to 10 wt% in the first blue light-emitting layer, and the second blue dopant may be present in an amount of 0.1 wt% to 10 wt% in the second blue light-emitting layer.

In a light-emitting device according to one aspect of the present disclosure, an asymmetric hole trap region biased toward the first blue light-emitting layer may be generated in the first blue light-emitting layer and the second blue light-emitting layer in contact with each other.

In a light-emitting device according to another aspect of the present disclosure may comprise a first electrode and a second electrode facing each other over a substrate and a first blue stack, a first charge generation layer, a phosphorescent stack and a second blue stack between the first electrode and the second electrode. The first blue stack sequentially comprises a first hole transport layer, a first blue light-emitting unit, and a first electron transport layer, the second blue stack sequentially comprises a second hole transport layer, a second blue light-emitting unit, and a second electron transport layer, at least one of the first and second blue light-emitting units comprises first and second blue light-emitting layers, and the first and second blue light-emitting layers comprise the same host BH and comprise different first and second blue dopants, respectively, and the first blue dopant has a higher HOMO energy level than a HOMO energy level of the first hole transport layer or the second hole transport layer.

In the light-emitting device, the HOMO energy level of the first blue dopant is at least 0.1 eV higher than the HOMO energy level of the first hole transport layer or the second hole transport layer, and the HOMO energy level of the host is at least 0.5 eV lower than the HOMO energy level of the first blue dopant.

In the light-emitting device, an asymmetric hole trap region biased toward the first blue light-emitting layer is generated in the first blue light-emitting layer and the second blue light-emitting layer coming into contact with each other.

In the light-emitting device, a thickness ratio of the first blue light-emitting layer to the second blue light-emitting layer is 1:8 to 8:2.

In the light-emitting device, the phosphorescent stack comprises a red light-emitting layer, a yellow-green light-emitting layer and a green light-emitting layer adjacent to the first charge generation layer.

A display device according to one aspect of the present disclosure may comprise a substrate comprising a plurality of subpixels, a thin film transistor provided in each of the subpixels on the substrate and the light-emitting device as stated above, connected to the thin film transistor in at least one of the subpixels.

It will be apparent to those skilled in the art that various modifications and variations can be made in the present disclosure without departing from the scope of the disclosure defined by the appended claims.

## Claims

1. A light-emitting device comprising:
a first electrode (110) and a second electrode (200) facing each other over a substrate (100); and
a first blue stack (BS1; S1) and a first charge generation layer (150) between the first electrode (110) and the second electrode (200), wherein
the first blue stack (BS1; S1) comprises a first hole transport layer (122; 1230), a first blue light-emitting layer (1241; 2241), a second blue light-emitting layer (1242; 2242), and a first electron transport layer (125; 1250) sequentially arranged between the first electrode (110) and the second electrode (200),
the first and second blue light-emitting layers (1241, 1242) comprise the same first host (BH), the first blue light-emitting layer (1241; 2241) comprises a first blue dopant (BD1), and the second blue light-emitting layer (1242; 2242) comprises a second blue dopant (BD2) different from the first blue dopant (BD1), and
the first blue dopant (BD1) has a higher Highest Occupied Molecular Orbital energy level (BD1 HOMO) than a Highest Occupied Molecular Orbital energy level (HTL_HOMO) of the first hole transport layer (122; 1230).

2. The light-emitting device according to claim 1, wherein the Highest Occupied Molecular Orbital energy level (HTL_HOMO) of the first hole transport layer (122; 1230) is between a Highest Occupied Molecular Orbital energy level (BH HOMO) of the first host and the Highest Occupied Molecular Orbital energy level (BD1_HOMO) of the first blue dopant (BD1),
wherein optionally the Highest Occupied Molecular Orbital energy level (BD1_HOMO) of the first blue dopant (BD1) is at least 0.1 eV higher than the Highest Occupied Molecular Orbital energy level (HTL HOMO) of the first hole transport layer (122; 1230), and/or the Highest Occupied Molecular Orbital energy level (BH HOMO) of the first host (BH) is at least 0.5 eV lower than the Highest Occupied Molecular Orbital energy level (BD1_HOMO) of the first blue dopant (BD1).

3. The light-emitting device according to any one of claims 1 or 2, wherein a thickness ratio of the first blue light-emitting layer (1241; 2241) to the second blue light-emitting layer (1242; 2242) is 1:9 to 8:2, optionally 1:8 to 8:2.

4. The light-emitting device according to any one of claims 1 to 3, wherein the first blue light-emitting layer (1241; 2241) has an emission peak of 440 nm to 470 nm and/or the second blue light-emitting layer (1242; 2242) has an emission peak of 440 nm to 470 nm.

5. The light-emitting device according to any one of claims 1 to 4, wherein the first blue dopant (BD1) is present in an amount of 0.1 wt% to 10 wt% in the first blue light-emitting layer (1241; 2241), and/or
the second blue dopant (BD2) is present in an amount of 0.1 wt% to 10 wt% in the second blue light-emitting layer (1242; 2242).

6. The light-emitting device according to any one of claims 1 to 5, wherein an asymmetric hole trap region biased toward the first blue light-emitting layer (1241; 2241) is generated in the first blue light-emitting layer (1241; 2241) and the second blue light-emitting layer (1242; 2242) in contact with each other.

7. The light-emitting device according to any one of claims 1 to 6, further comprising a second blue stack (S3), wherein optionally the second blue stack (S3) is positioned between the first blue stack (S1) and the second electrode (200), and further optionally the second blue stack (S3) has the same configuration as the first blue stack (S1).

8. The light-emitting device according to claim 7, wherein the second blue stack (S3) comprises a second hole transport layer (141), a third blue light-emitting layer (2251), a fourth blue light-emitting layer (2252), and a second electron transport layer (144) sequentially arranged between the first electrode (110) and the second electrode (200),
the third and fourth blue light-emitting layers (2251, 2252) comprise the same second host (BH), the third blue light-emitting layer (2251) comprises a third blue dopant, and the fourth blue light-emitting layer (2252) comprises a fourth blue dopant different from the third blue dopant, and
the third blue dopant has a higher Highest Occupied Molecular Orbital energy level than a Highest Occupied Molecular Orbital energy level of the second hole transport layer.

9. The light-emitting device according to claim 8, wherein the Highest Occupied Molecular Orbital energy level of the second hole transport layer (141) is between a Highest Occupied Molecular Orbital energy level of the second host and the Highest Occupied Molecular Orbital energy level of the third blue dopant,
wherein optionally the Highest Occupied Molecular Orbital energy level of the third blue dopant is at least 0.1 eV higher than the Highest Occupied Molecular Orbital energy level of the second hole transport layer (141), and/or the Highest Occupied Molecular Orbital energy level of the second host is at least 0.5 eV lower than the Highest Occupied Molecular Orbital energy level of the third blue dopant.

10. The light-emitting device according to any one of claims 8 or 9, wherein a thickness ratio of the third blue light-emitting layer (2251) to the fourth blue light-emitting layer (2252) is 1:8 to 8:2.

11. The light-emitting device according to any one of claims 8 to 10, wherein the third blue light-emitting layer (2251) has an emission peak of 440 nm to 470 nm and/or the fourth blue light-emitting layer (2252) has an emission peak of 440 nm to 470 nm.

12. The light-emitting device according to any one of claims 8 to 11, wherein the third blue dopant is present in an amount of 0.1 wt% to 10 wt% in the third blue light-emitting layer (2251), and/or
the fourth blue dopant is present in an amount of 0.1 wt% to 10 wt% in the fourth blue light-emitting layer (2252).

13. The light-emitting device according to any one of claims 8 to 12, wherein an asymmetric hole trap region biased toward the third blue light-emitting layer (2251) is generated in the third blue light-emitting layer (2251) and the fourth blue light-emitting layer (2252) in contact with each other.

14. The light-emitting device according to any one of claims 1 to 13, further comprising a phosphorescent stack (S2) positioned between the first electrode (110) and the second electrode (200), the phosphorescent stack (S2) comprising a red light-emitting layer (132) and/or a yellow-green light-emitting layer (133) and/or a green light-emitting layer (134) adjacent to the first charge generation layer (150).

15. A light-emitting display device comprising:
a substrate (100) comprising a plurality of subpixels (R_SP, G_SP, B_SP, W_SP);
a plurality of thin film transistors respectively provided in the subpixels (R_SP, G_SP, B_SP, W_SP) over the substrate (100); and
the light-emitting device according to any one of claims 1 to 14, connected to at least one of the thin film transistors in at least one of the subpixels (R_SP, G_SP, B_SP, W_SP).
